(19) Europäisches Patentamt
European Patent Office
Office européen des brevets

(11) **EP 4 401 193 A1**

(12) **EUROPEAN PATENT APPLICATION**

(43) Date of publication:
**17.07.2024 Bulletin 2024/29**

(21) Application number: **23211955.2**

(22) Date of filing: **24.11.2023**

(51) International Patent Classification (IPC):
**H01M 10/48** (2006.01)   **H01M 10/0525** (2010.01)
**G01R 31/367** (2019.01)   **G01R 31/392** (2019.01)
**H01M 10/42** (2006.01)

(52) Cooperative Patent Classification (CPC):
**H01M 10/0525; G01R 31/367; G01R 31/392;**
**H01M 10/425; H01M 10/4285; H01M 10/482;**
**H01M 10/486;** H01M 2010/4271; H01M 2010/4278

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **16.01.2023  KR 20230006306**

(71) Applicant: **Samsung SDI Co., Ltd.**
**Yongin-si, Gyeonggi-do 17084 (KR)**

(72) Inventors:
• **CHUN, Changyoon**
 **17084 Yongin-si (KR)**
• **KIM, Hwasu**
 **17084 Yongin-si (KR)**

(74) Representative: **Marks & Clerk LLP**
**15 Fetter Lane**
**London EC4A 1BW (GB)**

(54) **METHOD AND APPARATUS FOR DIAGNOSING BATTERY ABNORMALITIES BY USING ELECTROCHEMICAL MODEL OF BATTERY**

(57)    A method of diagnosing battery abnormalities including acquiring at least one parameter of the battery, and determining, based on, salt precipitation of the battery by using an electrochemical model calculated based on a single particle model of a cathode and an anode of the battery, the electrochemical model comprising a model configured to calculate internal lithium ion concentrations of the cathode and the anode by considering a difference in diffusion of lithium ions between the cathode and the anode of the battery and to estimate an internal state of the battery by using a difference between the internal lithium ion concentrations of the cathode and the anode.

**FIG. 11**

START

MEASURE PARAMETER OF BATTERY — S210

DIAGNOSE SALT PRECIPITATION OF BATTERY BY USNG ELECTROCHEMICAL MODEL CALCULATED ON BASIS OF SINGLE PARTICLE MODEL OF CATHODE AND ANODE OF BATTERY — S220

END

EP 4 401 193 A1

**Description**

**BACKGROUND**

**1. Field**

Aspects of embodiments of the present disclosure relate to a method and apparatus for diagnosing battery abnormalities by using an electrochemical model of a battery.

**2. Description of the Related Art**

Estimation of the internal states of batteries is one of the most significant factors to consider in battery management and control. For example, estimation of states of charge (SOCs), states of health (SOHs), and states of power is very significant in monitoring and maintaining the performance of batteries in real time.

In order to estimate the internal states of batteries, attempts have been made to numerically model lithium-ion secondary batteries to understand migration in the lithium-ion secondary batteries in a quantitative and theoretical manner. In addition, recently, electrochemical models such as single particle models (SPMs) have been used in battery research.

Lithium plating of batteries may reduce the amount of available lithium, thus reducing the lifespan of the batteries, or may produce an internal short circuit due to the generation of lithium dendrites. In particular, at a low temperature, ion conductivity of electrolytes is lowered, and thus, diffusion of lithium ions in electrolytes is slowed, and diffusion of lithium ions into anode active materials is also slowed. As described above, when the diffusion of lithium ions is slowed and thus lithium ions in electrolytes fail to be diffused into anodes, lithium is highly likely to be precipitated. The above issues may become more pronounced as batteries age.

The above information disclosed in this Background section is only for enhancement of understanding of the background of the invention and therefore it may contain information that does not form the prior art.

**SUMMARY**

Aspects of some embodiments of the present disclosure are directed to a method and apparatus for diagnosing battery abnormalities by using an electrochemical model of a battery. However, the above problems are examples, and the scope of the disclosure is not limited thereby.

Additional aspects will be set forth in part in the description which follows and, in part, will be apparent from the description, or may be learned by practice of the presented embodiments of the disclosure.

According to some embodiments of the present disclosure, there is provided a method of diagnosing battery abnormalities by using a processor configured to estimate an internal state of a battery, the method comprising: acquiring at least one parameter of the battery; and determining, based on, salt precipitation of the battery by using an electrochemical model calculated based on a single particle model of a cathode and an anode of the battery, the electrochemical model comprising a model configured to calculate internal lithium ion concentrations of the cathode and the anode by considering a difference in diffusion of lithium ions between the cathode and the anode of the battery and to estimate an internal state of the battery by using a difference between the internal lithium ion concentrations of the cathode and the anode.

In some embodiments, the diagnosing the salt precipitation of the battery comprises: estimating a potential of an electrolyte between the anode and a separator of the battery; estimating a potential of the anode of the battery; and calculating a value of an overpotential between the anode and the separator of the battery by using the potential of the electrolyte and the potential of the anode and diagnosing the salt precipitation of the battery based on the value of the overpotential.

In some embodiments, the estimating the potential of the electrolyte between the anode and the separator of the battery comprises estimating the potential of the electrolyte based on the electrochemical model by using the difference between the internal lithium ion concentrations occurring due to a diffusion difference between the cathode and the anode of the battery.

In some embodiments, the electrochemical model comprises a model configured to calculate the internal lithium ion concentrations of the cathode and the anode of the battery by discretizing the single particle model of the cathode and the anode of the battery into a sphere having a plurality of layers, and by using a diffusion coefficient according to concentration distributions of the cathode and the anode of the battery, the diffusion coefficient being determined according to a concentration and a temperature of each layer of the plurality of layers of the single particle model.

In some embodiments, the electrochemical model comprises a model configured to estimate a voltage of the battery based on a value of an overpotential that is a difference between a measured voltage of the battery and an open-circuit voltage of the battery.

In some embodiments, the electrochemical model comprises a model configured to calculate a value of a priori overpotential by using information regarding a lithium ion concentration of an outermost layer from among the plurality of layers of the single particle model, information regarding an average lithium ion concentration of the cathode and the anode of the battery, and voltage drop information of the battery, and to calculate the value of the overpotential by using the value of the priori overpotential and a predetermined overpotential proportional coefficient.

In some embodiments, the predetermined overpotential proportional coefficient comprises an experimental value for simulating, with a Butler-Volmer equation, a relationship between the value of the priori overpotential and the value of the overpotential by using curve fitting.

In some embodiments, a computer program stored in a recording medium executes the method described above by using a computing apparatus.

According to some embodiments of the present disclosure, there is provided an apparatus for diagnosing battery abnormalities, the apparatus comprising: a memory configured to store data generated by measuring at least one parameter of a battery; and a processor configured to diagnose, based on the at least one parameter, salt precipitation of the battery by using an electrochemical model calculated based on a single particle model of a cathode and an anode of the battery, the electrochemical model comprising a model configured to calculate internal lithium ion concentrations of the cathode and the anode by considering a difference in diffusion of lithium ions between the cathode and the anode of the battery and to estimate an internal state of the battery by using a difference between the lithium ion concentrations of the cathode and the anode.

In some embodiments, the processor is configured to estimate a potential of an electrolyte between the anode and a separator of the battery, to estimate a potential of the anode of the battery, to calculate a value of an overpotential between the anode and the separator of the battery by using the potential of the electrolyte and the potential of the anode, and to determine the salt precipitation of the battery based on the value of the overpotential.

In some embodiments, the processor is configured to estimate, based on the electrochemical model, the potential of the electrolyte by using the difference between the internal lithium ion concentrations occurring due to a diffusion difference between the cathode and the anode of the battery.

In some embodiments, the electrochemical model comprises a model configured to calculate the internal lithium ion concentrations of the cathode and the anode of the battery by discretizing a single particle model of the cathode and the anode of the battery into a sphere having a plurality of layers, the electrochemical model comprising a model configured to calculate the internal lithium ion concentrations of the cathode and the anode of the battery by using a diffusion coefficient according to concentration distributions of the cathode and the anode of the battery, the diffusion coefficient being determined according to a concentration and a temperature of each layer of the plurality of layers of the single particle model.

In some embodiments, the electrochemical model comprises a model configured to estimate a voltage of the battery based on a value of an overpotential that is a difference between a measured voltage of the battery and an open-circuit voltage of the battery.

In some embodiments, the electrochemical model comprises a model configured to calculate a value of a priori overpotential by using information regarding a lithium ion concentration of an outermost layer from among the plurality of layers of the single particle model, information regarding an average lithium ion concentration of the cathode and the anode of the battery, and voltage drop information of the battery, and to calculate the value of the overpotential by using the value of the priori overpotential and a predetermined overpotential proportional coefficient.

In some embodiments, the predetermined overpotential proportional coefficient comprises an experimental value for simulating, with a Butler-Volmer equation, a relationship between the value of the priori overpotential and the value of the overpotential by using curve fitting.

At least some of the above features that accord with the invention and other features according to the invention are set out in the claims.

**BRIEF DESCRIPTION OF THE DRAWINGS**

The above and other aspects, features, and advantages of certain embodiments of the disclosure will be more apparent from the following description taken in conjunction with the accompanying drawings, in which:

FIG. 1 is a block diagram schematically illustrating a battery pack according to some embodiments of the present disclosure;

FIG. 2 is an example view illustrating a single particle model (SPM) of a battery, according to some embodiments of the present disclosure;

FIG. 3 is a view illustrating a change in lithium ion concentration of a battery, according to some embodiments of the present disclosure;

FIG. 4 is a view illustrating a method of discretizing an SPM of a battery, according to some embodiments of the present disclosure;

FIG. 5 is a graph illustrating a Butler Volmer equation according to some embodiments of the present disclosure;

FIG. 6 is a flowchart illustrating a method of estimating an internal state of a battery, according to some embodiments of the present disclosure;

FIG. 7 is a graph illustrating a change in lithium ion concentration of a battery, according to some embodiments of the present disclosure;

FIG. 8 is a graph illustrating a method of diagnosing salt precipitation of a battery, according to some embodiments of the present disclosure;

FIG. 9 is a view illustrating a method of estimating a potential of an anode, according to some embodiments of the present disclosure;

FIG. 10 is a graph illustrating an effect of a method of diagnosing salt precipitation, according to some embodiments of the present disclosure; and

FIG. 11 is a flowchart illustrating a method of diagnosing battery abnormalities, according to some embodiments of the present disclosure.

## DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

Hereinafter, various embodiments will be described in detail with reference to the accompanying drawings so that one of ordinary skill in the art to which the disclosure pertains may easily implement the disclosure. However, the invention is not limited to the embodiments described herein, but is defined by the attached claims. When it is determined that the detailed description of the related known art may obscure explanation of the disclosure when describing embodiments disclosed herein, the detailed description of the known art has been omitted. Like reference numerals in the drawings denote like elements, and thus their description will be omitted.

Some embodiments may be described as functional block components and various processing operations. Some or all of these functional blocks may be implemented as various numbers of hardware and/or software components that execute a particular function. For example, functional blocks of the embodiments of the present disclosure may be implemented by one or more microprocessors, or by circuit components for a certain function. The functional blocks of the embodiments of the present disclosure may be implemented in various suitable programming or scripting languages. The functional blocks of the embodiments of the present disclosure may be implemented by an algorithm executed on one or more processors. Functions performed by the functional blocks of embodiments of the present disclosure may be performed by a plurality of functional blocks, or the functions performed by the plurality of functional blocks of embodiments of the present disclosure may be performed by a single functional block. In addition, the disclosure may employ the related art for electronic environment setting, signal processing, and/or data processing.

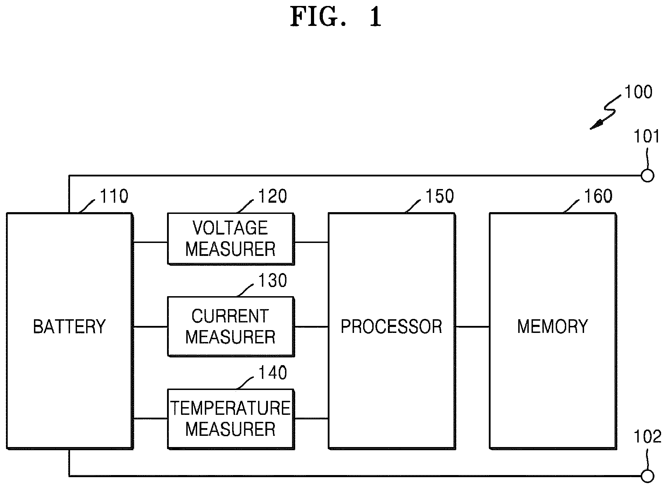

FIG. 1 is a block diagram schematically illustrating a battery pack according to some embodiments of the present disclosure.

Referring to FIG. 1, a battery pack 100 may include a battery 110, a processor 150, a memory 160, a voltage measurer 120, a current measurer 130, and a temperature measurer 140.

The battery 110 may include at least one battery cell, and the battery 110 may be a rechargeable secondary battery. For example, the battery 110 may include a lithium ion battery.

The number and connection method of battery cells included in the battery 110 may be determined on the basis of an amount of power, voltage, and the like demanded for the battery pack 100. For example, the battery cells may be connected to each other in parallel, or may be connected to each other in series and in parallel. Although FIG. 1 illustrates that the battery pack 100 includes one battery 110 for conceptual purposes only, the battery pack 100 may include a plurality of batteries 110 that are connected to each other in series, in parallel, or in series and in parallel. The battery 110 may also include only one battery cell.

The battery 110 may include a plurality of battery modules each including a plurality of battery cells. In addition, the battery pack 100 may include a pair of pack terminals 101 and 102 to which an electrical load or charge device may be connected.

As used herein, estimating an internal state of a battery may apply to the battery 110 or to each battery cell included in the battery 110. Although a method of estimating an internal state of one battery is described herein, the method may be equally applied to the estimation of an internal state of each of a plurality of battery cells included in the battery 110.

The battery pack 100 according to some embodiments includes a switch. The switch may be connected between the battery 110 and one of the pack terminals 101 and 102 (e.g., the pack terminal 101). The switch may be controlled by the processor 150. The battery pack 100 may further include a battery protection circuit, a fuse, a current sensor, and other common features of such batteries.

An apparatus for estimating an internal state of a battery, according to some embodiments, includes the processor 150 and the memory 160.

The processor 150 controls the overall operation of the apparatus for estimating an internal state of a battery. For example, the processor 150 may be implemented in a form, which selectively includes a processor, an application-specific integrated circuit (ASIC), another chipset, a logic circuit, a register, a communication modem, and/or a data processing device, which are known in the art, to perform the operations described above.

The processor 150 may perform basic arithmetic, logic, and input/output operations, and may execute, for example, a program code stored in the memory 160. The processor 150 may store data in the memory 160 or load data stored in the memory 160.

The memory 160 may be a recording medium that may be read by the processor 150 and may include a permanent mass storage device such as random access memory (RAM), read only memory (ROM), or a disk drive. The memory 160 may store an operating system and at least one program or application code. The memory 160 stores a program code for estimating an internal state of a battery, according to some embodiments. For example, the memory 160 may store data generated by measuring at least one parameter of the battery 110. In addition, the memory 160 may store a unique capacity of the battery 110. In addition, the memory 160 may store state of charge-open circuit voltage (SOC-OCV) data of the battery 110. For example, the data generated by measuring at least one parameter of the battery 110 may include a charge/discharge current, a terminal voltage, and/or a temperature of the battery 110. In addition, the data generated by measuring at least one parameter of the battery 110 may include a discharge rate of the battery 110. The memory 160 may store a program code and SOC-OCV data for estimating an SOC of the battery 110 by using data generated by measuring at least one parameter of the battery 110. The at least one parameter of the battery 110 refers to a component or variable such as a terminal voltage, a charge/discharge current, and/or an ambient temperature of the battery 110.

The apparatus for estimating an internal state of a battery may further include the voltage measurer 120, the current measurer 130, and the temperature measurer 140 for measuring at least one parameter of the battery 110. The apparatus for estimating an internal state of a battery may further include a communication module for communicating with another apparatus such as an electronic control apparatus of a vehicle, a controller of a charge device, or the like.

The voltage measurer 120 may be configured to measure a voltage of the battery 110. For example, as illustrated in the structure of FIG. 1, the voltage measurer 120 may be electrically connected to both ends of the battery 110. In addition, the voltage measurer 120 may be electrically connected to the processor 150 to transmit and receive an electrical signal. In addition, under control of the processor 150, the voltage measurer 120 may measure a voltage at both ends of the battery 110 at certain time intervals and output, to the processor 150, a signal indicating a magnitude of the measured voltage. Here, the processor 150 may determine a voltage of the battery 110 from the signal output from the voltage measurer 120. For example, the voltage measurer 120 may be implemented by using a voltage measurement circuit or any other suitable means.

In addition, the current measurer 130 may be configured to measure a current of the battery 110. For example, the current measurer 130 may be electrically connected to a current sensor provided on a charge/discharge path of the battery 110. In addition, the current measurer 130 may be electrically connected to the processor 150 to transmit and receive an electrical signal. In addition, under control of the processor 150, the current measurer 130 may repeatedly measure a magnitude of a charge current or discharge current of the battery 110 at certain time intervals and output, to the processor 150, a signal indicating the magnitude of the measured current. Here, the processor 150 may determine a magnitude of a current from the signal output from the current measurer 130. For example, a current sensor may be implemented by using a hall sensor, a sense resistor, or any other suitable means.

The temperature measurer 140 may be configured to measure a temperature of the battery 110. For example, as illustrated in the structure of FIG. 1, the temperature measurer 140 may be connected to the battery 110 to measure a temperature of a secondary battery provided in the battery 110. In addition, the temperature measurer 140 may be electrically connected to the processor 150 to transmit and receive an electrical signal. In addition, the temperature measurer 140 may repeatedly measure a temperature of the secondary battery at certain time intervals and output, to the processor 150, a signal indicating a magnitude of the measured temperature. Here, the processor 150 may determine a temperature of the secondary battery from the signal output from the temperature measurer 140. For example, the temperature measurer 140 may be implemented by using a thermocouple or any other suitable means.

In addition, the processor 150 may estimate an internal state of the battery 110 by using at least one of a voltage measurement value, a current measurement value, and a temperature measurement of the battery 110 received from the voltage measurer 120, the current measurer 130, and the temperature measurer 140. For example, the processor 150 may estimate a state of charge, SOC, of the battery 110. Here, the SOC may be calculated as a numerical value corresponding to a remaining amount of the battery 110 in a range of about 0 % to about 100 %.

In some embodiments, the processor 150 estimates the SOC of the battery 110 by integrating a charge/discharge current of the battery 110. Here, an initial value of the SOC when charging or discharging of the battery 110 starts may be determined by using an open circuit voltage, OCV, of the battery 110 measured before charging or discharging starts. To this end, the processor 150 may map an SOC corresponding to the OCV of the battery 110 from SOC-OCV data, on the basis of the SOC-OCV data that defines an SOC for each OCV.

In some examples, the processor 150 may estimate the SOC of the battery 110 by using an extended Kalman filter. The extended Kalman filter refers to a mathematical algorithm that adaptively estimates an SOC of the secondary battery by using a voltage, a current, and a temperature of the secondary battery.

The SOC of the battery 110 may also be determined by other known methods capable of estimating an SOC by selectively using a voltage, a current, and a temperature of the secondary battery, in addition to the current integration method or the extended Kalman filter described above.

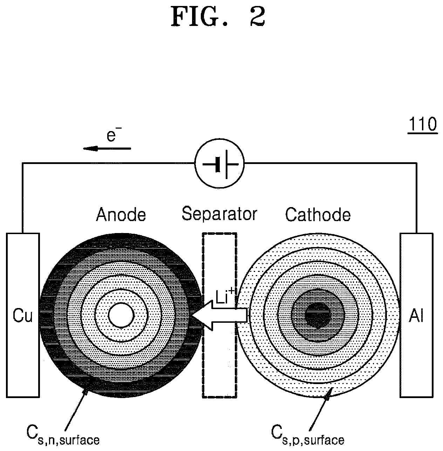

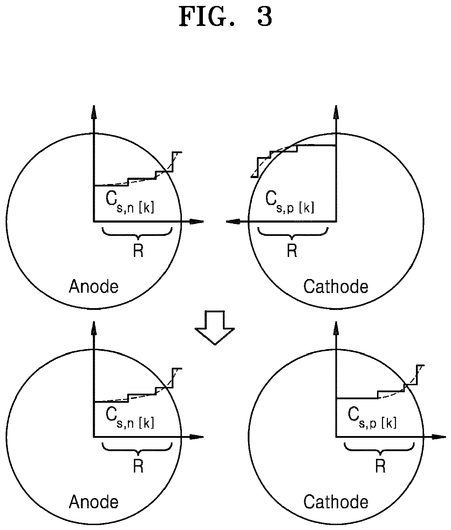

FIG. 2 is an example view illustrating a single particle model (SPM) of a battery, according to some embodiments of the present disclosure. In addition, FIG. 3 is a view illustrating a change in a lithium ion concentration of a battery, according to some embodiments of the present disclosure.

Referring to FIGS. 2 and 3, during charging, lithium ions are intercalated into an anode of a battery 110, and thus, a concentration of the lithium ions increases from an outermost layer. In contrast, lithium ions are released from a cathode, and thus, a concentration of the lithium ions decreases from an outermost layer. Here, boundary conditions applied to a cathode and an anode of an SPM of the battery 110 are the same as each other, and thus, an amount of lithium ions released from the cathode inside the SPM is the same as an amount of lithium ions intercalated into the anode.

In addition, when a concentration of the charged lithium ions of the anode of the battery 110 is divided by a maximum concentration $C_{s,max}$ that may be intercalated into the SPM, and then normalized, an SOC may be acquired. However, lithium ions are discharged from the cathode of the battery 110, and thus, a simulation may be made in a form in which a concentration decreases with an increase in an SOC. However, as illustrated in FIG. 3, even in a cathode of a battery, a concentration may be defined on the basis of an amount of lithium ions released, and thus, the amount of lithium ions released may be considered to increase with an increase in an SOC. Therefore, the concentration in the cathode is considered to be the same as in the anode. In other words, a concentration $C_s$ in the anode of the battery may be defined on the basis of an amount of increase and may be defined in the cathode of the battery on the basis of an amount of decrease. Here, $C_s$ may represent a lithium ion concentration, $C_{s,p}$ may represent a cathode lithium ion concentration (mol m$^{-3}$), and $C_{s,n}$ may represent an anode lithium ion concentration (mol m$^{-3}$). "R" in Figure 3 is the radius of the single particle in the SPM model.

For example, when a battery includes a cathode having $LiCoO_2$ and an anode having C and an SOC increases from 0 % to 100 % during charging, $Li_xC_6$ may increase from x=0 to x=1 in the anode and $Li_yCoO_2$ decreases from y=1 to y=0 in the cathode of the battery. Here, an SPM does not consider a concentration of lithium ions in an electrolyte, and thus, a sum of lithium ion concentrations of the cathode and the anode may be preserved, and thus may be represented as y=1-x. Therefore, when the formulas for the cathode and the anode are expanded based on x, the same equation may consider only a difference in diffusion of the cathode and anode. In addition, when an average concentration is calculated within a spherical structure used in the SPM, currents applied to the cathode and the anode are the same, and thus, values of average values $\overline{c_{s,p}}$ and $\overline{c_{s,n}}$ are the same as the SOC. Here, $\overline{c_{s,p}}$ may represent an average lithium concentration (mol m$^{-3}$) of the cathode, and $\overline{c_{s,n}}$ may represent an average lithium concentration (mol m$^{-3}$) of the anode.

In addition, the degrees of diffusion of the cathode and the anode of the battery are different from each other, and thus, diffusion differences may occur according to various SOCs and temperatures. Therefore, a difference may occur in a concentration gradient inside a cell voltage or a single particle, and may be extended and used to predict a concentration or potential of an electrolyte at an anode-separator portion.

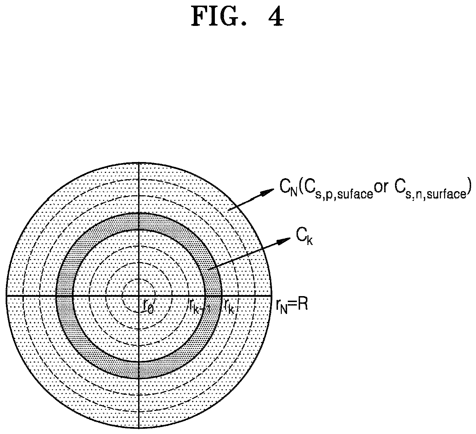

FIG. 4 is a view illustrating a method of discretizing an SPM of a battery, according to some embodiments of the present disclosure.

FIG. 4 illustrates a view in which an SPM of a cathode and an anode of a battery is discretized into a sphere having a plurality of layers, according to some embodiments.

Equation 1

$$\frac{\partial c_{s,p}}{\partial t} = \nabla \cdot \left( D_{s,p} \nabla c_{s,p} \right)$$

### Equation 2

$$\frac{\partial c_{s,n}}{\partial t} = \nabla \cdot \left( D_{s,n} \nabla c_{s,n} \right)$$

Here, $C_{s,p}$ may represent a cathode lithium ion concentration (mol m$^{-3}$), and $C_{s,n}$ may represent an anode lithium ion concentration (mol m$^{-3}$). In addition, $D_{s,p}$ may represent a diffusion coefficient (m$^2$s$^{-1}$) of cathode particles, and $D_{s,n}$ may represent a diffusion coefficient (m$^2$s$^{-1}$) of anode particles.

For example, as illustrated in FIG. 4, when estimating an internal state of the battery by developing equations of Equations 1 and 2 for each of $C_{s,p}$ $C_{s,n}$, an SPM of the battery may be divided into spheres having N layers and may be discretized, respectively, as in Equations 3 to 7. In detail, Equations 1 and 2 may be discretized as in Equations 3, and boundary conditions at both ends of a layer may be checked to solve Equation 3. In addition, diffusion may not develop further inward in a first layer, and thus, as in Equation 4, a concentration changes according to a boundary condition outside the sphere in an N$^{th}$ layer (the outermost layer), and thus may be expressed as in Equation 5. In other words, a relationship in Equation 6 is according to a relationship between a current and a capacity coming from the outside, and Equation 7 may be expressed by substituting Equation 6 into Equation 5.

### Equation 3

$$\frac{\partial c_k}{\partial t} = \frac{3}{(r_k{}^3 - r_{k-1}{}^3)}\left[\left(D_{s,r_k} r_k{}^2 \frac{(C_{k+1} - C_k)}{(r_{k+1} - r_{k-1})/2}\right) - \left(D_{s,r_{k-1}} r_{k-1}{}^2 \frac{(C_k - C_{k-1})}{(r_k - r_{k-2})/2}\right)\right]$$

### Equation 4

$$\frac{\partial c_1}{\partial t} = \frac{6 D_{s,r_1}}{(r_1 \cdot r_2)}[C_2 - C_1]$$

### Equation 5

$$\frac{\partial c_N}{\partial t} = \frac{6}{(R^3 - r_{N-1}{}^3)}\left[D_{s,R}\left(\frac{R^2}{2}\right)\frac{\partial c}{\partial r}\bigg|_{r=R} - D_{s,r_{N-1}}\left(\frac{r_{N-1}{}^2}{R - r_{N-2}}\right)C_N + D_{s,r_{N-1}}\left(\frac{r_{N-1}{}^2}{R - r_{N-2}}\right)C_{N-1}\right]$$

### Equation 6

$$\varphi = -D_{s,R}\frac{\partial c}{\partial r}\bigg|_{r=R} = \frac{I}{\delta A \varepsilon \frac{3}{R} F}$$

### Equation 7

$$\frac{\partial c_N}{\partial t} = \frac{6}{(R^3 - r_{N-1}{}^3)}\left[\left(-\frac{R^2 \varphi}{2}\right) - D_{s,r_{N-1}}\left(\frac{r_{N-1}{}^2}{R - r_{N-2}}\right)C_N + D_{s,r_{N-1}}\left(\frac{r_{N-1}{}^2}{R - r_{N-2}}\right)C_{N-1}\right]$$

Here, ' may represent a battery current (in Amperes, A), R may represent a radius (in meters, m) of electrode particles, A may represent an area (m$^2$) of an electrode, $\delta$ may represent a thickness (m) of the electrode, F may represent a faraday constant (C/mol), and $\varepsilon$ may represent a volume fraction of an active material. $r_k$ represents the section of the radius in the k$^{th}$ layer.

Equations of Equations 1 and 2 may be discretized as in Equations 3 to 7 to be developed for each of a cathode and an anode. In addition, $D_{s,r_k}$ represents a diffusion coefficient according to concentration distributions of the cathode and the anode, and is a value determined by a concentration and a temperature of a corresponding position.

Equation 8

$$V = OCP_p\left(\overline{c_{s,p}}/c_{s,max}\right) - OCP_n\left(\overline{c_{s,n}}/c_{s,max}\right) + \eta$$

Equation 9

$$\eta = f(OCP_p\left(c_{s,p,surface}/c_{s,max}\right), \ OCP_n\left(c_{s,n,surface}/c_{s,max}\right), \ OCP_p\left(\overline{c_{s,p}}/c_{s,max}\right), OCP_n\left(\overline{c_{s,n}}/c_{s,max}\right), R_o, I, T)$$

Equation 10

$$\eta_- = (OCP_p\left(c_{s,p,surface}/c_{s,max}\right) - OCP_n\left(c_{s,n,surface}/c_{s,max}\right)) - (OCP_p\left(\overline{c_{s,p}}/c_{s,max}\right) - OCP_n\left(\overline{c_{s,n}}/c_{s,max}\right)) + I * R_o$$

Equation 11

$$\eta = k_R \frac{\eta_-}{1+|\eta_-|}$$

Here, $R_o$ may represent a resistance (Ohm), T may represent a temperature (°C, or K) of the battery, an OCP may represent an open-circuit potential, $OCP_p$ may represent an OCP of the cathode, $OCP_n$ may represent an OCP of the anode, $C_{s,p,surface}$ may represent a lithium concentration (mol m$^{-3}$) of the outermost layer of the cathode, and $C_{s,n,surface}$ may represent a lithium concentration (mol m$^{-3}$) of the outermost layer of the anode. In addition, $\overline{c_{s,p}}$ may represent an average lithium concentration (mol m$^{-3}$) of the cathode, and $\overline{c_{s,n}}$ may represent an average lithium concentration (mol m$^{-3}$) of the anode. In addition, $K_R$ may represent an overpotential proportional coefficient.

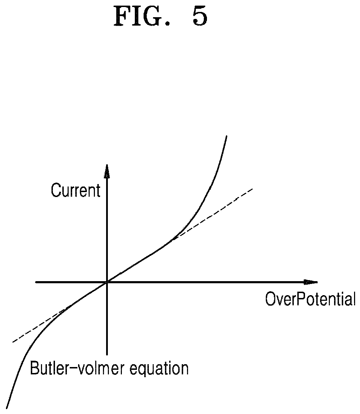

$\eta$ represents an overpotential. The overpotential may be a difference between a cell voltage V and an OCV in Equation 8, and the cell voltage may be predicted by substituting Equation 9 into Equation 8. However, a value $\eta$- of an a priori overpotential, which is calculated in an electrochemical model, according to some embodiments, differs from a value $\eta$ of an actual overpotential. The difference occurs due to a Butler-Volmer relationship. For example, referring to FIG. 5 together, a Butler-Volmer relationship is illustrated.

In some embodiments, a relationship between the value $\eta$- of the a priori overpotential and the value $\eta$ of the actual overpotential is generalized as in Equation 11 that may simulate the Butler-Volmer relationship by using the difference between the cell voltage and the OCV actually measured in Equations 10 and 8 as calculated in the electrochemical model. For example, the overpotential proportional coefficient $K_R$ is an empirical value derived through experimentation and is an example using curve fitting. According to some embodiments, a relationship between a current density and an overpotential may be derived without iteration by using the relationship between the value $\eta$- of the a priori overpotential and the value $\eta$ of the actual overpotential.

Equation 10 may be derived by using the outermost concentrations of the cathode and the anode of the battery, average lithium concentration information of the cathode and the anode, and IR drop information, and the voltage V measured in Equation 8 and the average lithium concentration information of the cathode and the anode may be transformed into an OCP, and a relationship between the OCP and the value $\eta$ of the actual overpotential may be derived via curve fitting as in Equation 11 above.

In relation to Equations 8 to 11, an OCV according to an SOC may be derived by subtracting an SOC of an anode OCP from an SOC of a cathode OCP, as in Equation 12 below.

Equation 12

$$OCP_p\left(\overline{c_{s,p}}/c_{s,max}\right) - OCP_n\left(\overline{c_{s,n}}/c_{s,max}\right) = OCP_p(SOC) - OCP_n(SOC) = OCV(SOC)$$

Here, $SOC_p = \overline{c_{s,p}}/c_{s,max}$ represents a value equivalent to an average lithium ion concentration divided by the maximum concentration released from the cathode, and thus represents the SOC of the cathode. Also, $SOC_n = \overline{c_{s,n}}/c_{s,max}$

represents a value equivalent to an average lithium ion concentration divided by the maximum concentration coming into the anode, and thus represents the SOC of the anode. In addition, in $SOC_p=SOC_n=SOC$, both the cathode and anode are single particles, and thus the SOCs of the cathode and the anode are the same as SOC.

In Equation 8, when the value of $\eta$ the overpotential is defined as a difference between a measured cell voltage V and a voltage OCV when stabilized, the overpotential may be obtained by subtracting the voltage of the OCV from the measured cell voltage V. Also, when the relationship between the value $\eta$ of the overpotential and the value $\eta$- of the a priori overpotential may be represented graphically, with data obtained through experimentation. Curve fitting is then performed to simulate the Butler-Volmer equation, an equation as in Equation 12 and the overpotential proportional coefficient $K_R$ may be calculated. For example, the overpotential proportional coefficient may also be calculated by using a sigmoid function, a logistic function, a hyperbolic tangent, an arctangent, an algebraic function, or the like.

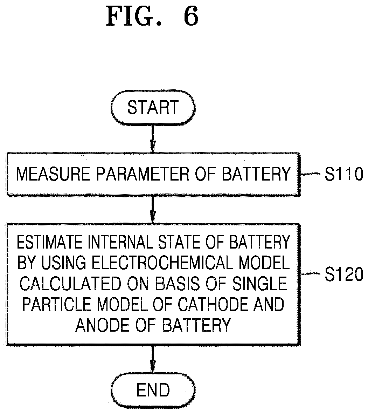

FIG. 6 is a flowchart illustrating a method of estimating an internal state of a battery, according to some embodiments of the present disclosure. The method of estimating an internal state of a battery, according to some embodiments, may be performed by the processor 150 illustrated in FIG. 1. Here, the processor 150 may estimate, on the basis of at least one parameter of a battery, an internal state of the battery by using an electrochemical model calculated on the basis of an SPM of a cathode and an anode of the battery.

Referring to FIG. 6, in operation S110, the processor 150 may acquire at least one parameter of a battery. For example, the at least one parameter according to some embodiments includes a voltage, a current, and a temperature of the battery.

In operation S120, the processor 150 may estimate, on the basis of the at least one parameter of the battery, an internal state of the battery by using an electrochemical model calculated on the basis of an SPM of a cathode and an anode of the battery.

The electrochemical model according to some embodiments is a model that calculates internal lithium ion concentrations of the cathode and the anode by considering a difference in diffusion of lithium ions between the cathode and the anode of the battery, and estimates the internal state of the battery by using a difference between lithium ion concentrations of the cathode and the anode.

Also, the electrochemical model according to some embodiments is a model that calculates the internal lithium ion concentrations of the cathode and the anode of the battery by discretizing the SPM of the cathode and the anode of the battery into spheres each having a plurality of layers.

In addition, the electrochemical model according to some embodiments is a model that calculates the internal lithium ion concentrations of the cathode and the anode of the battery by using a diffusion coefficient according to concentration distributions of the cathode and the anode of the battery.

The diffusion coefficient according to some embodiments is determined according to a concentration and a temperature of each layer of the plurality of layers of the SPM of the cathode and the anode of the battery.

In addition, the electrochemical model according to some embodiments is a model that estimates a voltage of the battery on the basis of a value of an overpotential that is a difference between a measured voltage of the battery and an OCV of the battery.

Also, the electrochemical model according to some embodiments is a model that calculate a value of an a priori overpotential by using information regarding a lithium ion concentration of the outermost layer from among the plurality of layers of the SPM of the cathode and the anode of the battery, information regarding an average lithium ion concentration of the cathode and the anode of the battery, and voltage drop information of the battery.

In addition, the electrochemical model according to some embodiments is a model that calculates a value of an overpotential by using the value of the a priori overpotential and a predetermined overpotential proportional coefficient.

In addition, the predetermined overpotential proportional coefficient according to some embodiments is an experimental value for simulating a relationship between the value of the a priori overpotential and the value of the overpotential with a Butler-Volmer equation by using curve fitting.

According to some embodiments, a battery model is an electrochemical model in the form of a single particle and may be a reduce order model that reduces an amount of calculation that is mainly affected by internal diffusion of solid particles rather than diffusion of an electrolyte, and parameters thereof may be represented as diffusion and resistance of the cathode and the anode.

Also, even in the case of an equivalent model, the battery model according to some embodiments is a model capable of deriving a surface SOC that is a similar concept to calculation of a surface Li-density of an electrochemical model.

In addition, the battery model according to some embodiments is a model capable of deriving Li-density information inside the cathode and the anode by considering a diffusion difference between the cathode and the anode.

In addition, the battery model according to some embodiments is expanded to a model that predicts a concentration and potential of an electrolyte by using an Li-density distribution inside the cathode and the anode and the Li-density information difference between the cathode and the anode that occur due to a difference in diffusion between the cathode and the anode, and predicts a potential of a particular position (e.g., an anode potential of an anode-separator portion) via the predicted concentration and potential.

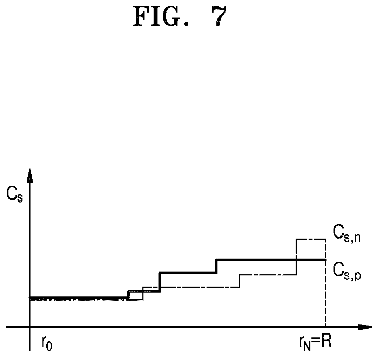

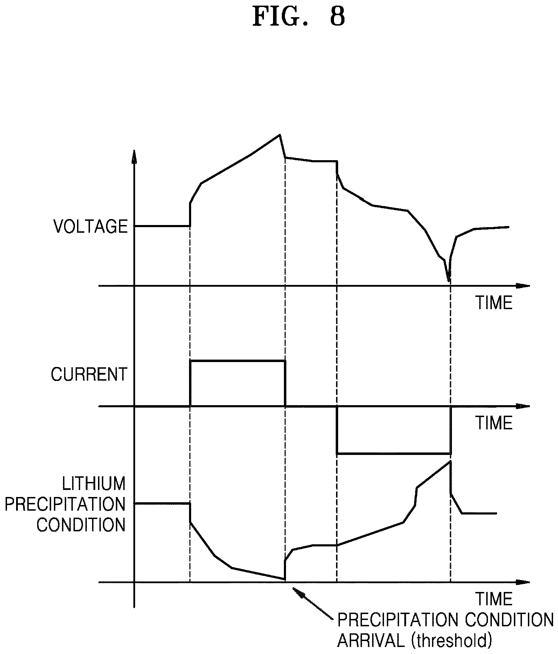

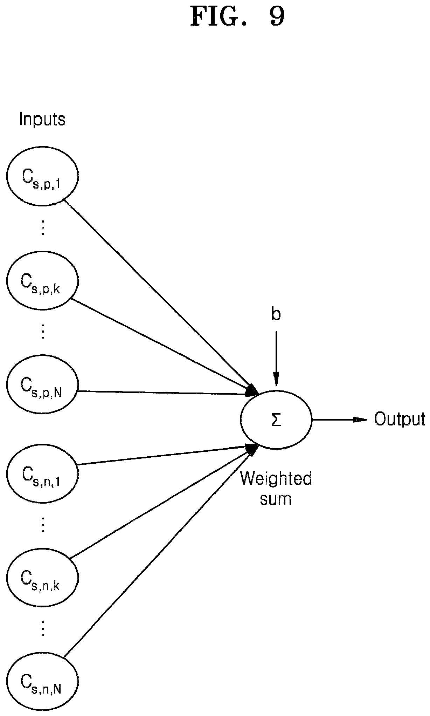

FIG. 7 is a graph illustrating a change in lithium ion concentration of a battery, according to some embodiments of the present disclosure; and FIG. 8 is a graph illustrating a method of diagnosing salt precipitation of a battery, according to some embodiments of the present disclosure. In addition, FIG. 9 is a view illustrating a method of estimating a potential of an anode, according to some embodiments of the present disclosure.

A salt precipitation condition occurs when lithium ions of an electrolyte fail to reach an anode that has an anode active material, and thus is highly likely to occur at a low temperature or at a great charge current, and in particular, is more highly likely to occur at the anode and a separator. Therefore, it is desired to calculate a potential of the electrolyte and a potential of the anode at an anode-separator position, and to diagnose whether or not a value of an overpotential of the anode-separator position is less than or equal to 0. For example, as illustrated in FIG. 8, salt precipitation may be prevented or substantially reduced by controlling a current or voltage of a battery so that a value of an overpotential is not less than or equal to a threshold value (e.g., a value of an overpotential is not less than or equal to 0) corresponding to a salt precipitation condition. Accordingly, rapid aging of a cell due to salt precipitation may be preemptively prevented or substantially reduced , and a short circuit inside the cell may be prevented or instances thereof may be substantially reduced.

When an SOC based on an electrochemical model according to some embodiments is used, a gradient inside an SPM is changed due to a difference in diffusion between a cathode and an anode, and a potential of an electrolyte may be estimated by using a difference between internal gradients described above. For example, the difference between the internal gradients may include an outermost/innermost lithium concentration difference, a lithium concentration difference between the outermost layers of the cathode and the anode, a difference between gradients of lithium concentrations of the cathode and the anode, and/or the like.

In addition, a potential of the anode, which is an anode active material, may be derived as in Equation 15 through a lithium concentration of the outermost layer and a resistance of the anode. For example, referring to FIG. 9 together with Equation 15, the potential of the anode may be estimated through lithium ion concentration information of the cathode and the anode, and weight and bias of the information by using a neural network. Here, the weight and bias of the information may be empirical values derived and obtained through experiments.

Equation 13

$$\eta_{an-sep} = f(c_{s,p}, c_{s,n}, OCP_n(c_{s,n,surface}/c_{s,max}), R_o, I, T)$$

Equation 14

$$\eta_{an-sep} = \phi_{s,n} - \phi_{e,an-sep} = OCP_n(c_{s,n,suface}/c_{s,max}) - I * R_{o,n} - f(c_{s,p}, c_{s,n})$$

Equation 15

$$f(c_{s,p}, c_{s,n}) = \sum_{k}^{N} w_{1,k} c_{s,p,k} + \sum_{k}^{N} w_{2,k} c_{s,n,k} + b$$

In Equation 14, $\eta_{an-sep}$ indicates a value of an overpotential between an anode and a separator of a battery. $\eta_{an-sep}$ is a potential of an anode solid particle at a position at which the anode and the separator are in contact with each other, and the corresponding potential is determined by a difference between an outermost potential $\phi_{s,n}$ of a solid particle at the corresponding position and an electrolyte potential $\phi_{e,an-sep}$ at the corresponding position.

Electrolyte potentials of the cathode and the anode may also be considered, but when a difference between the electrolyte potentials of the cathode and the anode is not great compared to a potential difference between solid particles of the cathode and the anode, a cell voltage may be calculated as in Equation 16 below.

## Equation 16

$$V \approx \phi_{s,p} - \phi_{s,n} = \left(OCP_p\left(c_{s,p,surface}/c_{s,max}\right) + I * R_{o,p}\right) - \left(OCP_n\left(c_{s,n,surface}/c_{s,max}\right) - I * R_{o,n}\right) =$$

$$OCV(SOC) + I * \left(R_{o,p} + R_{o,n}\right) = OCV(SOC) + I * R_o$$

In other words, an outermost potential of particles of the anode may be $OCR_n(c_{s,n,surface}/c_{s,max}) - I * R_{o,n}$ expressed as because the value obtained by subtracting a potential of the anode from a potential of the cathode is the cell voltage. Here, the direction of current is expressed as + during charging and - during discharging.

## Equation 17

$$\eta_{an-sep} < 0$$

However, the salt precipitation condition indicates that a Li+/Li reduction potential is 0 V (e.g., the Li reduction potential is set to 0 V as a reference potential), and thus, salt precipitation may occur in a condition of Equation 17. The salt precipitation may be prevented from occurring or substantially reduced by controlling the battery so that the salt precipitation condition is not less than or equal to 0 V.

However, a cell has a three-dimensional structure and a model error may occur, and thus, a salt precipitation condition potential may be used for battery control and diagnosis by deriving a threshold value $V_{th}$ (e.g., a threshold voltage) through experimentation. Here, as in Equation 18, the salt precipitation condition indicates that the salt precipitation may occur when less than or equal to the threshold value $V_{th}$.

## Equation 18

$$\eta_{an-sep} < V_{th}$$

In this case, a potential $\phi_{e,an-sep}$ of an electrolyte, which is not present in a model, may be derived, and a value of the potential may allow a relationship equation to be derived through a difference in a concentration gradient between the cathode and the anode. (Here, weight and bias coefficients may be derived through experimentation.)

## Equation 19

$$\phi_{e,an-sep} = f\left(c_{s,p}, c_{s,n}\right) = \sum_{k}^{N} w_{1,k} c_{s,p,k} + \sum_{k}^{N} w_{2,k} c_{s,n,k} + b$$

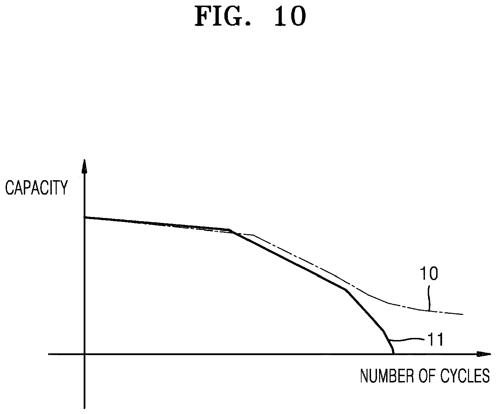

FIG. 10 is a graph illustrating an effect of a method of diagnosing salt precipitation, according to some embodiments of the present disclosure.

FIG. 10 illustrates a graph 10 indicating the number of cycles with respect to a capacity of a battery to which salt precipitation prevention according to some embodiments is applied, and a graph 11 indicating the number of cycles with respect to a capacity of a battery to which salt precipitation prevention is not applied.

When the salt precipitation prevention according to some embodiments is applied, the battery is controlled to prevent salt precipitation from occurring, and thus, the life of the battery may be increased by preventing a short circuit inside a cell and rapid aging of the cell.

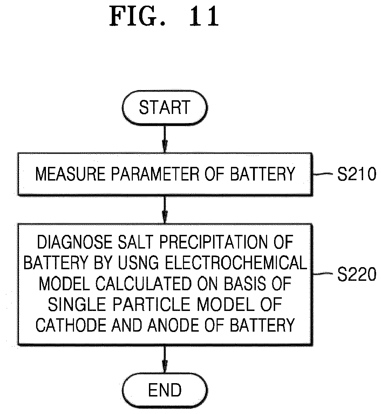

FIG. 11 is a flowchart illustrating a method of diagnosing battery abnormalities, according to some embodiments of the present disclosure. The method of diagnosing battery abnormalities, according to some embodiments, is performed by the processor 150 illustrated in FIG. 1. Here, the processor 150 may diagnose, on the basis of at least one parameter of a battery, salt precipitation of the battery by using an electrochemical model calculated on the basis of an SPM of a cathode and an anode of the battery.

Referring to FIG. 11, in operation S210, the processor 150 may acquire at least one parameter of a battery.

For example, the at least one parameter according to some embodiments includes a voltage, a current, and a temperature of the battery.

In operation S220, the processor 150 may diagnose, on the basis of the at least one parameter of the battery, salt precipitation of the battery by using an electrochemical model calculated on the basis of an SPM of a cathode and an anode of the battery.

The electrochemical model according to some embodiments is a model that calculates internal lithium ion concentrations of the cathode and the anode by considering a difference in diffusion of lithium ions between the cathode and the anode of the battery, and estimates an internal state of the battery by using a difference between lithium ion concentrations of the cathode and the anode.

The processor 150 according to some embodiments estimates a potential of an electrolyte between the anode and a separator of the battery. In addition, the processor 150 may estimate a potential of the anode of the battery. Also, the processor 150 may calculate a value of an overpotential between the anode and the separator of the battery by using the potential of the electrolyte and the potential of the anode, and diagnose salt precipitation of the battery on the basis of the value of the overpotential.

In addition, the processor 150 may estimate, on the basis of the electrochemical model, the potential of the electrolyte by using a difference in an internal lithium ion concentration occurring due to a diffusion difference between the cathode and the anode of the battery.

According to some embodiments, on the basis of an SPM in which active materials of a cathode and an anode of a battery are expressed in one sphere, abnormalities of the battery may be diagnosed while overcoming the limitation of a cell voltage simulation occurring due to a lithium ion concentration of an electrolyte in a region with a great current, which is a drawback in the related art. The scope of the disclosure is not limited by the effects described above.

Various embodiments described above are illustrative and do not have to be distinguished from each other and implemented independently. At least some of the embodiments described herein may be implemented in combination with each other.

The various embodiments described above may be implemented in the form of computer programs that may be executed through various components on a computer, and the computer programs may be recorded on a computer-readable medium. Here, the medium may continue to store a computer-executable program or may temporarily store the computer-executable program for execution or download. In addition, the medium may be various types of recording units or storage units in the form of a single piece of hardware or combinations of several pieces of hardware, may not be limited to a medium directly connected to any computer system, and may be distributed on a network. Examples of the medium may include a magnetic medium such as a hard disk, a floppy disk, or a magnetic tape, an optical recording medium such as CD-ROM or DVD, a magneto-optical medium such as a floptical disk, ROM, RAM, flash memory, and the like, and the medium may be configured to store program instructions. In addition, examples of other media include recording media or storage media managed by app stores that distribute applications, sites that supply or distribute various types of software, servers, or the like.

As used herein, a noun followed by the "-er" suffix, the term "module", etc. may be hardware components such as processors or circuits, and/or software components executed by hardware components such as processors. For example, a verb followed by the "-er", the term "module", etc. may be implemented by components, such as software components, object-oriented software components, class components, and task components, processes, functions, properties, procedures, subroutines, segments of program code, drivers, firmware, microcode, circuits, data, databases, data structures, tables, arrays, and variables.

The above description of some embodiments of the present disclosure is for illustrative purposes only, and one of ordinary skill in the art to which the disclosure pertains may understand that the description may be easily modified into other particular forms whilst being within the scope of the claims. Therefore, it should be understood that the embodiments described above are examples in all respects and are not limited. For example, each component described as a single type may be implemented in a distributed manner, or components described as similarly distributed may be implemented in a combined form.

The terminology used herein is for the purpose of describing particular embodiments and is not intended to be limiting of the inventive concept. As used herein, the singular forms "a" and "an" are intended to include the plural forms as well, unless the context clearly indicates otherwise. It will be further understood that the terms "include," "including," "comprises," "comprising," "has," "have," and "having," when used in this specification, specify the presence of stated features, integers, steps, operations, elements, and/or components, but do not preclude the presence or addition of one or more other features, integers, steps, operations, elements, components, and/or groups thereof.

As used herein, the term "and/or" includes any and all combinations of one or more of the associated listed items. For example, the expression "A and/or B" denotes A, B, or A and B. Expressions such as "one or more of" and "at least one of," when preceding a list of elements, modify the entire list of elements and do not modify the individual elements of the list. For example, the expression "one or more of A, B, and C," "at least one of A, B, or C," "at least one of A, B, and C," and "at least one selected from the group consisting of A, B, and C" indicates only A, only B, only C, both A and B, both A and C, both B and C, or all of A, B, and C.

Further, the use of "may" when describing embodiments of the inventive concept refers to "one or more embodiments of the inventive concept." Also, the term "exemplary" is intended to refer to an example or illustration.

It will be understood that when an element or layer is referred to as being "on", "connected to", "coupled to", or "adjacent" another element or layer, it can be directly on, connected to, coupled to, or adjacent the other element or layer, or one or more intervening elements or layers may be present. When an element or layer is referred to as being "directly on," "directly connected to", "directly coupled to", "in contact with", "in direct contact with", or "immediately adjacent" another element or layer, there are no intervening elements or layers present.

As used herein, the term "substantially," "about," and similar terms are used as terms of approximation and not as terms of degree, and are intended to account for the inherent variations in measured or calculated values that would be recognized by those of ordinary skill in the art.

As used herein, the terms "use," "using," and "used" may be considered synonymous with the terms "utilize," "utilizing," and "utilized," respectively.

The scope of the disclosure should be defined by claims described below, and equivalents thereof, rather than by the description, and all changes or modifications derived from the meaning and scope of the claims and their equivalent concepts should be interpreted as being included in the scope of the disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims.

**Claims**

1. A method of diagnosing battery abnormalities comprising:

   acquiring at least one parameter of a battery; and
   determining, based on, salt precipitation of the battery by using an electrochemical model calculated based on a single particle model of a cathode and an anode of the battery, the electrochemical model comprising a model configured to calculate internal lithium ion concentrations of the cathode and the anode by considering a difference in diffusion of lithium ions between the cathode and the anode of the battery and to estimate an internal state of the battery by using a difference between the internal lithium ion concentrations of the cathode and the anode.

2. The method of claim 1, wherein the diagnosing the salt precipitation of the battery comprises:

   estimating a potential of an electrolyte between the anode and a separator of the battery;
   estimating a potential of the anode of the battery; and
   calculating a value of an overpotential between the anode and the separator of the battery by using the potential of the electrolyte and the potential of the anode and diagnosing the salt precipitation of the battery based on the value of the overpotential.

3. The method of claim 2, wherein the estimating the potential of the electrolyte between the anode and the separator of the battery comprises estimating the potential of the electrolyte based on the electrochemical model by using the difference between the internal lithium ion concentrations occurring due to a diffusion difference between the cathode and the anode of the battery.

4. The method of any preceding claim, wherein the electrochemical model comprises a model configured to calculate the internal lithium ion concentrations of the cathode and the anode of the battery by discretizing the single particle model of the cathode and the anode of the battery into a sphere having a plurality of layers, and by using a diffusion coefficient according to concentration distributions of the cathode and the anode of the battery, the diffusion coefficient being determined according to a concentration and a temperature of each layer of the plurality of layers of the single particle model.

5. The method of claim 4, wherein the electrochemical model comprises a model configured to estimate a voltage of the battery based on a value of an overpotential that is a difference between a measured voltage of the battery and an open-circuit voltage of the battery.

6. The method of claim 5, wherein the electrochemical model comprises a model configured to calculate a value of an a priori overpotential by using information regarding a lithium ion concentration of an outermost layer from among the plurality of layers of the single particle model, information regarding an average lithium ion concentration of the cathode and the anode of the battery, and voltage drop information of the battery, and to calculate the value of the overpotential by using the value of the a priori overpotential and a predetermined overpotential proportional coefficient.

7. The method of claim 6, wherein the predetermined overpotential proportional coefficient comprises an empirical value for simulating, with a Butler-Volmer equation, a relationship between the value of the a priori overpotential and the value of the overpotential by using curve fitting.

8. A computer program stored in a recording medium to execute the method of any preceding claim by using a computing apparatus.

9. An apparatus for diagnosing battery abnormalities, the apparatus comprising:

a memory configured to store data generated by measuring at least one parameter of a battery; and
a processor configured to diagnose, based on the at least one parameter, salt precipitation of the battery by using an electrochemical model calculated based on a single particle model of a cathode and an anode of the battery, the electrochemical model comprising a model configured to calculate internal lithium ion concentrations of the cathode and the anode by considering a difference in diffusion of lithium ions between the cathode and the anode of the battery and to estimate an internal state of the battery by using a difference between the internal lithium ion concentrations of the cathode and the anode.

10. The apparatus of claim 9, wherein the processor is configured to estimate a potential of an electrolyte between the anode and a separator of the battery, to estimate a potential of the anode of the battery, to calculate a value of an overpotential between the anode and the separator of the battery by using the potential of the electrolyte and the potential of the anode, and to determine the salt precipitation of the battery based on the value of the overpotential.

11. The apparatus of claim 10, wherein the processor is configured to estimate, based on the electrochemical model, the potential of the electrolyte by using the difference between the internal lithium ion concentrations occurring due to a diffusion difference between the cathode and the anode of the battery.

12. The apparatus of any of claims 9 to 11, wherein the electrochemical model comprises a model configured to calculate the internal lithium ion concentrations of the cathode and the anode of the battery by discretizing a single particle model of the cathode and the anode of the battery into a sphere having a plurality of layers, the electrochemical model comprising a model configured to calculate the internal lithium ion concentrations of the cathode and the anode of the battery by using a diffusion coefficient according to concentration distributions of the cathode and the anode of the battery, the diffusion coefficient being determined according to a concentration and a temperature of each layer of the plurality of layers of the single particle model.

13. The apparatus of claim 12, wherein the electrochemical model comprises a model configured to estimate a voltage of the battery based on a value of an overpotential that is a difference between a measured voltage of the battery and an open-circuit voltage of the battery.

14. The apparatus of claim 13, wherein the electrochemical model comprises a model configured to calculate a value of an a priori overpotential by using information regarding a lithium ion concentration of an outermost layer from among the plurality of layers of the single particle model, information regarding an average lithium ion concentration of the cathode and the anode of the battery, and voltage drop information of the battery, and to calculate the value of the overpotential by using the value of the a priori overpotential and a predetermined overpotential proportional coefficient.

15. The apparatus of claim 14, wherein the predetermined overpotential proportional coefficient comprises an empirical value for simulating, with a Butler-Volmer equation, a relationship between the value of the a priori overpotential and the value of the overpotential by using curve fitting.

# FIG. 1

FIG. 2

# FIG. 3

# FIG. 4

...

# FIG. 5

Current

OverPotential

Butler-volmer equation

# FIG. 6

```
        ┌─────────┐
        │  START  │
        └────┬────┘
             ▼
┌───────────────────────────────┐
│  MEASURE PARAMETER OF BATTERY  │─── S110
└───────────────┬───────────────┘
                ▼
┌───────────────────────────────┐
│ ESTIMATE INTERNAL STATE OF     │
│ BATTERY BY USING ELECTRO-      │
│ CHEMICAL MODEL CALCULATED ON   │─── S120
│ BASIS OF SINGLE PARTICLE MODEL │
│ OF CATHODE AND ANODE OF        │
│ BATTERY                        │
└───────────────┬───────────────┘
                ▼
        ┌─────────┐
        │   END   │
        └─────────┘
```

# FIG. 7

# FIG. 8

VOLTAGE

TIME

CURRENT

TIME

LITHIUM
PRECIPITATION
CONDITION

TIME
PRECIPITATION CONDITION
ARRIVAL (threshold)

# FIG. 9

# FIG. 10

# FIG. 11

```
        ( START )
            │
            ▼
┌────────────────────────────┐
│ MEASURE PARAMETER OF BATTERY │──── S210
└────────────────────────────┘
            │
            ▼
┌────────────────────────────┐
│  DIAGNOSE SALT PRECIPITATION OF │
│ BATTERY BY USNG ELECTROCHEMICAL │──── S220
│  MODEL CALCULATED ON BASIS OF  │
│    SINGLE PARTICLE MODEL OF    │
│  CATHODE AND ANODE OF BATTERY  │
└────────────────────────────┘
            │
            ▼
         ( END )
```

Europäisches
Patentamt

European
Patent Office

Office européen
des brevets

# EUROPEAN SEARCH REPORT

Application Number

EP 23 21 1955

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/276172 A1 (NISHI YUJI [JP]) 5 November 2009 (2009-11-05) * paragraphs [0002], [0011] - [0018], [0052] - [0059], [0067] - [0076], [0106], [0114] - [0172]; figures 1-20 * | 1-15 | INV. H01M10/48 H01M10/0525 G01R31/367 G01R31/392 H01M10/42 |
| X | EP 3 806 270 A1 (LG CHEMICAL LTD [KR]; UNIV AUBURN [US]) 14 April 2021 (2021-04-14) | 1-7 | |
| Y | * paragraphs [0005], [0018], [0019], [0021], [0022], [0023], [0026], [0028], [0032] - [0064], [0079] - [0083], [0087], [0088] - [0090] * * paragraphs [0115] - [0117], [0143] - [0201] * | 8-15 | |
| X | LEE HYEONGGEON ET AL: "Multiscale modeling of dendrite formation in lithium-ion batteries", COMPUTERS & CHEMICAL ENGINEERING, PERGAMON PRESS, OXFORD, GB, vol. 153, 19 June 2021 (2021-06-19), XP086726589, ISSN: 0098-1354, DOI: 10.1016/J.COMPCHEMENG.2021.107415 [retrieved on 2021-06-19] | 1-7 | TECHNICAL FIELDS SEARCHED (IPC) H01M G01R |
| Y | * the whole document * | 8-15 | |

The present search report has been drawn up for all claims

| Place of search | Date of completion of the search | Examiner |
|---|---|---|
| Munich | 17 May 2024 | Möller, Claudia |

EPO FORM 1503 03.82 (P04C01)

## ANNEX TO THE EUROPEAN SEARCH REPORT
## ON EUROPEAN PATENT APPLICATION NO.

EP 23 21 1955

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2024

| Patent document cited in search report | | Publication date | Patent family member(s) | | Publication date |
|---|---|---|---|---|---|
| US 2009276172 | A1 | 05-11-2009 | CN | 101512365 A | 19-08-2009 |
| | | | EP | 2063280 A1 | 27-05-2009 |
| | | | JP | 2008058278 A | 13-03-2008 |
| | | | KR | 20090057300 A | 04-06-2009 |
| | | | US | 2009276172 A1 | 05-11-2009 |
| | | | WO | 2008029572 A1 | 13-03-2008 |
| EP 3806270 | A1 | 14-04-2021 | CN | 111801870 A | 20-10-2020 |
| | | | EP | 3806270 A1 | 14-04-2021 |
| | | | JP | 7082208 B2 | 07-06-2022 |
| | | | JP | 2021515356 A | 17-06-2021 |
| | | | KR | 20200069203 A | 16-06-2020 |
| | | | US | 2021013731 A1 | 14-01-2021 |

EPO FORM P0459

For more details about this annex : see Official Journal of the European Patent Office, No. 12/82